# EUROPEAN PATENT SPECIFICATION

(11) **EP 0 756 332 B1**
(45) Date of publication and mention of the grant of the patent: **08.03.2000**
(21) Application number: 96111712.4
(22) Date of filing: 19.07.1996
(51) Int. Cl.: H01L 29/94

(54) **MOS capacitor of a semiconductor device**
MOS-Kapazität für Halbleiteranordnung
Capacité MOS pour dispositif semi-conducteur

(30) Priority: 21.07.1995 KR 2163195
(43) Date of publication of application: 29.01.1997
(73) Proprietor: Samsung Electronics Co., Ltd., Suwon-city, Kyungki-do (KR)
(72) Inventor: Choi, Hoon, Suwon-city, Kyungki-do (KR); Oh, Seung-Cheol, Suwon-city, Kyungki-do (KR)
(74) Representative: Eisenführ, Speiser & Partner

(56) References cited:
- EP-A- 0 472 297
- GB-A- 2 268 829
- US-A- 4 830 975
- PATENT ABSTRACTS OF JAPAN vol. 6, no. 32 (E-096), 26 February 1982 & JP-A-56 153778 (TOSHIBA CORP), 27 November 1981,

## Description

The present invention relates to a MOS (metal oxide semiconductor) capacitor of a semiconductor device, and more particularly to a capacitor having a constant capacitance.

In the prior art, a main issue in a MOS capacitor of a semiconductor device is to increase an effective storage capacity per an area and is to provide a gate oxide film which is not destructed by an electric field generated by an applied voltage. MOS capacitors are generally manufactured in two kinds of structures.

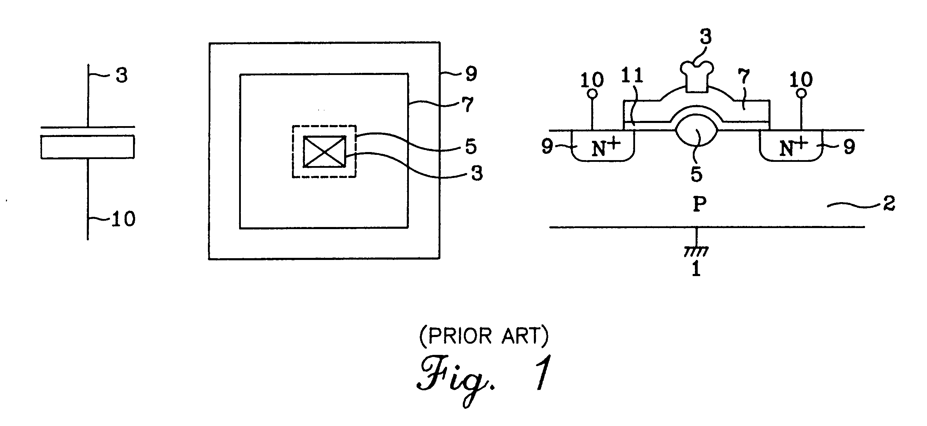

Fig. 1 is a view illustrating a structure of a MOS capacitor according to the prior art. In Fig. 1, a symbolic view, a planar view and a sectional view of the MOS capacitor are illustrated. Referring to Fig. 1, the MOS capacitor according to the prior art comprises: a semiconductor substrate 2 being formed in a first conductive type (for example, a P-type doped with 3-valence impurity), a lower part of the semiconductor substrate 2 being connected to a ground voltage terminal 1; a diffusion region 9 being formed by diffusing a second conductive type of an impurity (for example, an N-type doped with 5-valence impurity) from an upper surface into the semiconductor substrate 2, at a certain distance (for example, an area which is occupied by a gate electrode) therebetween; a first insulating film (a separate oxide film) 5 being formed by oxidation, said first insulating film 5 being positioned on the upper surface of the semiconductor substrate 2 and between the diffusion region 9; a second insulating film 11 being formed by depositing a silicon oxide film onto a portion of an upper surface of the diffusion region 9, onto the upper surface of the semiconductor substrate 2 and onto the upper surface of the first insulating film 5 which are positioned between the diffusion region 9; a gate electrode 7 being formed by depositing a polysilicon onto the upper surface of the second insulating film 11; a first electrode 3 being connected to the upper surface of the gate electrode 7 with an aluminum as much as the area which is occupied by the first insulating film 5; and a second electrode 10 being connected to and supplying a charge with the diffusion region 9.

Describing the operation of the above MOS capacitor of Fig. 1, if an internal power voltage is applied to the first electrode 3 and the ground voltage is applied to the source region of the diffusion region 9 through the second electrode 10, an electron channel is formed from the source region to the drain region. An electron of the electron channel is charged on the second insulating film. At this time, there has been a problem in which the capacitance is varied according to a voltage bias applied between the first electrode 3 and the second electrode 10 of the MOS capacitor.

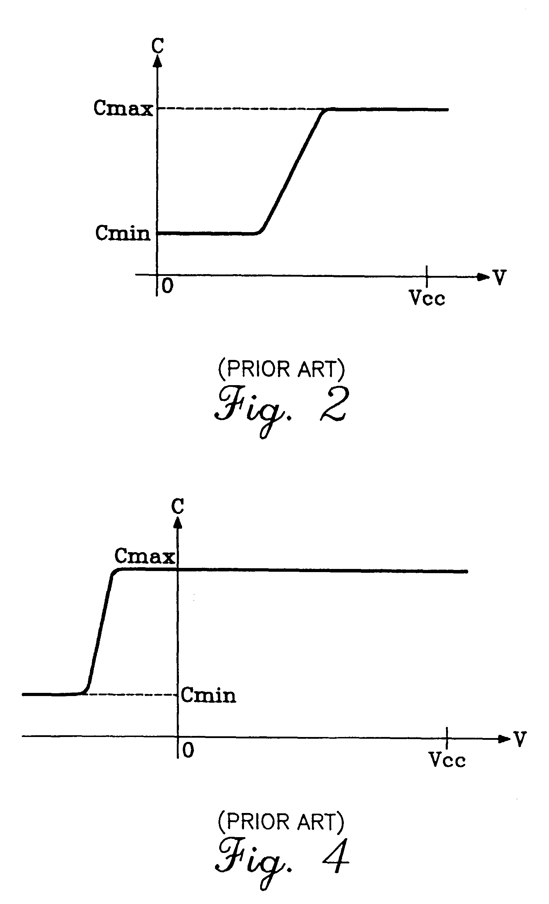

Fig. 2 is a view illustrating a characteristic diagram of the capacitance depending upon the applied voltage of the structure of Fig. 1. Referring to Fig. 2, when a voltage from the ground voltage 0 V to the internal power voltage Vcc is applied, the capacitance slowly increases according to the applied voltage bias, thereby to delay a time from an initial charging to a full charging. Therefore, it can be appreciated that the capacitance varies according to the applied voltage bias in a working range of the applied voltage. Accordingly, there has been a problem in which a reliability of a product deteriorates due to the variation of the capacitance.

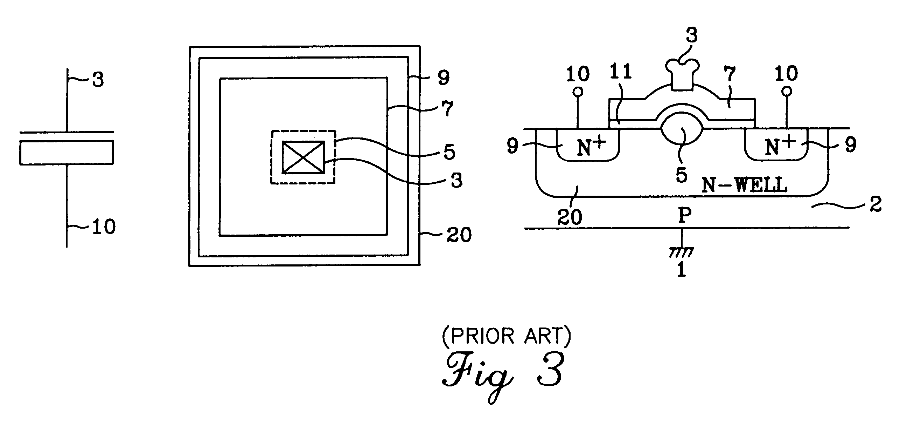

Another structure of a MOS capacitor having an improved capacitance behaviour for solving the above problems is illustrated in Fig. 3. In comparison with Fig. 1, the MOS capacitor of Fig. 3 further comprises: a diffusion region 9 which is ion-injected in a high concentration; and a second conductive type (for example, N-type) of a well-shaped diffusion region 20 being formed by diffusing the second conductive type of the impurity from the upper surface into the semiconductor substrate 2 before the diffusion region 9 is formed. Describing the operation of the MOS capacitor of Fig. 3 which is different from that of the MOS capacitor of Fig. 1, it is that, before the initial ground voltage is applied, the electron is generated from the source region to the drain region of the diffusion region 9 through the diffusion region 20, thereby to charge the electron onto the second insulating film 11. Accordingly, the capacitance does not vary (for example, in the working range from ground voltage to internal power voltage) by forming the well-shaped diffusion region 20.

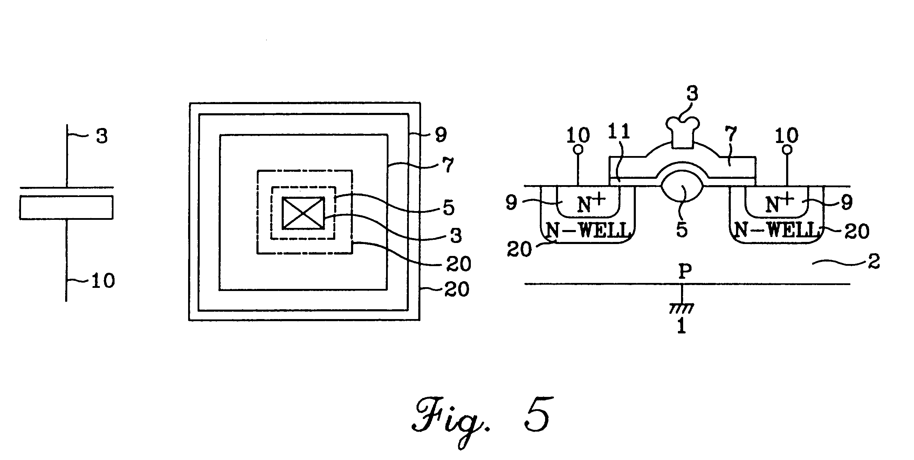

Fig. 4 is a view illustrating a characteristic diagram of the capacity C depending upon the applied voltage of Fig. 3. As appreciated from Fig. 4, when the applied voltage bias is varied from ground voltage 0 V to the internal power voltage Vcc, a maximum capacitance is constantly maintained from an initial state. Accordingly, there is an effect in which the MOS capacitor having a larger capacity per unit area is formed, since the capacitance does not vary even though the applied voltage bias is varied. However, there is caused a problem of the MOS capacitor of Fig. 3 in its process. To form the first electrode 3 of the MOS capacitor, a contact window is formed in the gate electrode 7 of a polycide. The thin second insulating film 11 (for example, a silicon nitride film) is formed under the polycide utilized as the gate electrode 7. The thick first insulating film 5 (for example, the separate silicon oxide film) is formed in a portion which the contact window is to be formed in. Accordingly, as appreciated from the structure of Fig. 3, there has been a problem in which a voltage bias of the first and second electrodes 3 and 10 causes a break-through in the fragile portion of both ends of the separate oxide film, thereby to destruct the MOS capacitor. In the case of Fig. 1, since a conductive type of a portion below the gate is P-type doped with an acceptor and the conductive type of the source region is the N-type doped with a donor, an electric field is lowered as much as a potential barrier of a PN junction, thereby to substantially reduce the electric field applied to the second insulating film 11 more than the electric field of Fig. 3. In other words, a voltage obtained by subtracting a threshold voltage of the MOS capacitor from a difference between voltage biases of the first and second electrodes 3 and 10 is applied to the second insulating film 11.

There has been a problem in the MOS capacitor of Fig. 3 comparing with that of Fig. 1 in which a portion below the gate electrode is formed in the N-type well, so that a substantial electric field is applied to the gate electrode and the second insulating film 11 (for example, the silicon nitride film) as much as a difference between voltage biases of the first and second electrodes 3 and 10, and thus the bias voltage applied to the second insulating film 11 (for example, the silicon nitride film) is larger than that of the MOS capacitor of Fig. 1, thereby to cause the break-through in the fragile second insulating film 11 (for example, the silicon nitride film).

It is therefore an object of the invention to provide a MOS capacitor with a constant capacitance in a working range of an applied voltage and increasing the capacitance per unit area, in which a break-through by a voltage bias applied to both ends of a separate oxide film.

To achieve this object, the present invention provides an MOS capacitor of a semiconductor device, comprising: a semiconductor substrate being, formed by doping a first conductive type of an impurity thereto; a first, ring-shaped diffusion region being formed by diffusing a second conductive type opposite to said first conductivity type of an impurity into an upper surface of the semiconductor substrate, leaving a certain space therebetween a second, ring-shaped diffusion region being formed by diffusing and ion-injecting the second conductive type of the impurity in a high concentration from an upper surface into said first diffusion region; a first insulating film being formed by an ion-injection onto an upper part of the semiconductor substrate positioned in the space of said diffusion region; a second insulating film being formed on the semiconductor substrate, an upper surface of the first diffusion region and a portion surface of the second diffusion region, to store a charge therein; a gate area being formed on an upper surface of the second insulating film, and a first electrode being formed on an upper surface of the gate area as much as an area which is occupied by the first insulating film and adapted to be connected with external circuitry; and a second electrode being formed on an upper surface of the second diffusion region, and adapted to be connected with external circuitry.

Preferable embodiments are defined in dependent claims.

The following is a detailed description of the invention by the reference of their attachable drawings, in which like numbers indicate the same or similar elements;
- Fig. 1: is a view illustrating a structure of an MOS capacitor in the prior art.
- Fig. 2: is a view illustrating a characteristic diagram of the capacitance depending upon an applied voltage (V) of the structure of Fig. 1.
- Fig. 3: is a view illustrating a structure of an MOS capacitor of the prior art, having an improved capacitance characteristic.
- Fig. 4: is a view illustrating a characteristic diagram of a capacitance of the structure of Fig. 3 depending upon an applied voltage.
- Fig. 5: is a view illustrating a structure of an MOS capacitor according to the present invention.

Fig. 5 is a view illustrating a structure of an MOS capacitor according to the present invention. The structure of the MOS capacitor of Fig. 5 will be described with back-reference to Fig. 3.

It is a difference between the MOS capacitors of Figs. 3 and 5 that second diffusion regions 9 and a first insulating film 5 (for example, a separate oxide film) are surrounded by well-shaped diffusion regions 20 in Fig. 3, whereas the second diffusion regions 9 are respectively surrounded by the first diffusion regions 20 positioned below a second insulating film 11 (for example, a silicon oxide film) and well-shaped only to both ends of the first insulating film 5 (for example, the separate insulating film).

The difference between the MOS capacitors of Figs. 3 and 5 is that in the structure of Fig. 3 the diffusion region 9 and a first insulating film 5 (for example, a separate oxide film) are surrounded by a well-shaped diffusion region 20 extending over the whole width of the diffused region 9 including the first insulating film 5 whereas in the structure of Fig. 5 only the ring sections of the diffusion region 9 is surrounded by a diffusion region 20 positioned below a second insulating film 11 (for example, a silicon oxide film) and well-shaped only to both ends of the first insulating film 5 (for example, the separate insulating film).

In the MOS capacitor according to the present invention, the capacitance does not vary even though an applied bias voltage is varied, thereby to have a larger storage capacity per unit area, and the problem in which the MOS capacitor of Fig. 3 causes a break-through by the bias voltage in the fragile second insulating film 11 (for example, a silicon oxide film) positioned at both ends of the first insulating film 5 (for example, the separate oxide film) is eliminated, which would cause an erroneous operation of the MOS capacitor. The above-captioned problem is solved by the manner that, when the conductive type of a semiconductor substrate 2 is P-type doped with the acceptor, the first diffusion region 20 doped with a second conductive type (for example, N-type) of the impurity performs a diffusion only to the portions of both ends of the first insulating film 5, and the sections of the second diffusion region 9 doped with a high concentration of the second conductive type which are the same as that of the first diffusion region 20 are respectively surrounded by the well-shaped sections of the first diffusion region 20.

Also, the above-captioned problem can be solved by the manner that in the case that the gate electrode 7 is an N-type polycide doped with the donor, the P-type semiconductor substrate 2 doped with the acceptor is utilized in the adjacent portion below the first insulating film 5 (for example, the separate oxide film), and in the case that the gate electrode 7 is a P-type polycide, the N-type semiconductor substrate 2 is utilized in the adjacent portion below the first insulating film 5 (for example, the separate oxide film). In other words, the semiconductor substrate 2 doped with an impurity different from that of the gate electrode 7 is positioned at the adjacent portion below the first insulating film 5 (for example, the separate oxide film), so that the bias voltage is reduced as much as a potential barrier of the PN junction in the fragile second insulating film 11 (for example, the silicon nitride film) positioned at both ends of the first insulating film 5, thereby to reduce affection caused by the bias voltage. As a result, there is an effect in which the break-through is prevented from being generated in the second insulating film 11. And, the well-shaped sections of the first diffusion region 20 are formed below the gate electrode 7 having a distance with the first insulating film 5, so that the capacitance depending upon the applied bias voltage is constantly maintained. As a result, there is an effect in which the MOS capacitor according to the present invention has a larger storage capacity per unit area.

As described above, the MOS capacitor according to the present invention has advantages to have a larger storage capacity, the capacitance does not vary depending upon the applied bias voltage, and the bias voltage applied to the fragile portion of both ends of the separate oxide film (for example, the silicon oxide film) is reduced to prevent the break-through from being generated in the fragile portion, thereby to lower a poor quality rate of the MOS capacitor and to improve a reliability and a yield.

## Claims

1. MOS capacitor of a semiconductor device, comprising:
a semiconductor substrate (2) being formed by doping a first conductive type of an impurity thereto;
a first, ring-shaped diffusion region (20) being formed by diffusing a second conductive type opposite to said first conductivity type of an impurity into an upper surface of said semiconductor substrate (2), leaving a certain space therebetween;
a second, ring-shaped diffusion region (9) being formed by diffusing and ion-injecting said second conductive type of said impurity in a high concentration from an upper surface into said first diffusion region (20);
a first insulating film (5) being formed by an ion-injection onto an upper part of said semiconductor substrate (2) positioned in the space of said first diffusion region (20);
a second insulating film (11) being formed on said semiconductor substrate (2), an upper surface of said first diffusion region (20) and a portion surface of said second diffusion region (9), to store a charge therein;
a gate area (7) being formed on an upper surface of said second insulating film (11), and a first electrode (3) being formed on an upper surface of said gate area (7) as much as an area which is occupied by said first insulating film (5), and
adapted to be connected with external circuitry; and a second electrode (10) being formed on an upper surface of said second diffusion region (9), and adapted to be connected with external circuitry.

2. MOS capacitor as claimed in claim 1, wherein said first conductive type is a P-type, and said second conductive type is an N-type.

3. MOS capacitor as claimed in claim 1 or 2, wherein said first insulating film (5) is formed by a thick separate oxide film.

4. MOS capacitor as claimed in any of claims 1-3, wherein said first insulating film (5) is a silicon oxide.

5. MOS capacitor as claimed in any of claims 1-4, wherein said second insulating film (11) is a silicon nitride film.

6. MOS capacitor as claimed in any of claims 1-5, wherein said gate electrode (7) is made of a polycide.

7. MOS capacitor as claimed in any of claims 1-6, said first electrode (3) and said second electrode (10) are made of an aluminum.

## Patentansprüche

1. MOS-Kondensator einer Halbleiteranordnung,
mit einem Halbleitersubstrat (2), das mit Fremdatomen einer ersten Leitfähigkeitstype dotiert ist;
mit einer ersten, ringförmigen Diffusionsregion (20), die durch Diffundieren von Fremdatomen einer der ersten Leitfähigkeitstype entgegengesetzen Leitfähigkeitstype in die obere Fläche des Halbleitersubstrats (2) gebildet ist, wobei ein gewisser Zwischenraum dazwischen gelassen ist;
mit einer zweiten, ringförmigen Diffusionsregion (9), die durch Diffundieren und lonenimplantieren von Fremdatomen der zweiten Leitfähigkeitstype in hoher Konzentration von der oberen Fläche in die erste Diffusionsregion (20) gebildet ist;
mit einem ersten Isolationsfilm (5), der durch Ionenimplantation auf dem oberen Teil des Halbleitersubtrats (2) im Zwischenraum der ersten Diffusionsregion (20) gebildet ist;
mit einem zweiten Isolationsfilm (11), der auf dem Halbleitersubstrat (2), einer oberen Fläche der ersten Diffusionsregion (20) und einer Teilfläche der zweiten Diffusionsregion gebildet ist, um darin eine Ladung zu speichern;
mit einem Gate-Bereich (7) der auf der oberen Fläche des zweiten Isolationsfilms (11) gebildet ist;
mit einer ersten Elektrode (3), die auf der oberen Fläche des Gate-Bereichs (7) in einem Bereich gebildet ist, der durch den ersten Isolationsfilm (5) eingenommen wird, und die dazu ausgebildet ist, mit externen Schaltungskreisen verbunden zu werden; und
mit einer zweiten Elektrode (10), die auf der oberen Fläche der zweiten Diffusionsregion (9) gebildet und dazu ausgebildet ist, mit externen Schaltungskreisen verbunden zu werden.

2. MOS-Kondensator nach Anspruch 1,
dadurch gekennzeichnet, daß die erste Leitfähigkeitstype vom P-Typ und die zweite Leitfähigkeitstype vom N-Typ ist.

3. MOS-Kondensator nach Anspruch 1 oder 2,
dadurch gekennzeichnet, daß der erste Isolationsfilm (5) durch einen dicken, getrennten Oxidfilm gebildet ist.

4. MOS-Kondensator nach einem der Ansprüche 1 - 3,
dadurch gekennzeichnet, daß der erste Isolationsfilm (5) aus Siliziumoxid besteht.

5. MOS-Kondensator nach einem der Ansprüche 1 - 4,
dadurch gekennzeichnet, daß der zweite Isolationsfilm (11) ein Siliziumnitridfilm ist.

6. MOS-Kondensator nach einem der Ansprüche 1 - 5,
dadurch gekennzeichnet, daß die Gate-Elektrode (7) aus einem Polycid besteht.

7. MOS-Kondensator nach einem der Ansprüche 1 - 6,
dadurch gekennzeichnet, daß die erste Elektrode (3) und die zweite Elektrode (10) aus Aluminium bestehen.

## Revendications

1. Condensateur métal-oxyde-semiconducteur (MOS) d'un dispositif à semiconducteurs, comprenant :
un substrat semiconducteur (2) formé par dopage d'un premier type de conductivité d'une impureté dans celui-ci ;
une première région de diffusion de forme annulaire (20) formée par diffusion d'un deuxième type de conductivité opposé audit premier type de conductivité d'une impureté dans une surface supérieure dudit substrat semiconducteur (2) en laissant un certain espace entre eux ;
une deuxième région de diffusion de forme annulaire (9) formée par diffusion et injection d'ions dudit deuxième type de conductivité de ladite impureté sous une concentration élevée à partir d'une surface supérieure dans ladite première région de diffusion (20) ;
un premier film isolant (5) formé par injection d'ions sur une partie supérieure dudit substrat semiconducteur (2) positionné dans l'espace de ladite première région de diffusion (20) ;
un deuxième film isolant (11) formé sur ledit substrat semiconducteur (2), une surface supérieure de ladite première région de diffusion (20) et une surface de partie de ladite deuxième région de diffusion (9), de façon à y stocker une charge ;
une zone de grille (7) formée sur une surface supérieure dudit deuxième film isolant (11), et une première électrode (3) formée sur une surface supérieure de ladite zone de grille (7), aussi grande qu'une zone qui est occupée par ledit premier film isolant (5), et adaptée pour être connectée à des circuits externes ; et une deuxième électrode (10) formée sur une surface supérieure de ladite deuxième région de diffusion (9), et adaptée pour être connectée à des circuits externes.

2. Condensateur métal-oxyde-semiconducteur selon la revendication 1, dans lequel ledit premier type de conductivité est un type P, et ledit deuxième type de conductivité est un type N.

3. Condensateur métal-oxyde-semiconducteur selon la revendication 1 ou 2, dans lequel ledit premier film isolant (5) est formé par un film d'oxyde séparé épais.

4. Condensateur métal-oxyde-semiconducteur selon l'une quelconque des revendications 1 à 3, dans lequel ledit premier film isolant (5) est un oxyde de silicium.

5. Condensateur métal-oxyde-semiconducteur selon l'une quelconque des revendications 1 à 4, dans lequel ledit deuxième film isolant (11) est un film de nitrure de silicium.

6. Condensateur métal-oxyde-semiconducteur selon l'une quelconque des revendications 1 à 5, dans lequel ladite électrode de grille (7) est constituée d'un polysiliciure.

7. Condensateur métal-oxyde-semiconducteur selon l'une quelconque des revendications 1 à 6, ladite première électrode (3) et ladite deuxième électrode (10) étant réalisées en aluminium.
